# FASCICULE DE BREVET EUROPEEN

(11) **EP 0 354 135 B1**
(45) Date de publication et mention de la délivrance du brevet: **29.09.1993**
(21) Numéro de dépôt: 89420264.7
(22) Date de dépôt: 21.07.1989
(51) Int. Cl.: G01R 29/08, H05K 9/00, G12B 17/02

(54) **Procédé et dispositif de contrôle d'un écran électromagnétique quasi-fermé**
Verfahren und Vorrichtung zur Kontrolle eines quasi-geschlossenen elektromagnetischen Schirmes
Method and apparatus to check a quasi-sealed electromagnetic screen

(30) Priorité: 05.08.1988 FR 8810718
(43) Date de publication de la demande: 07.02.1990
(73) Titulaire: MERLIN GERIN, F-38240 Meylan (FR)
(72) Inventeur: Barrault, Michel, F-38050 Grenoble Cédex (FR); Broyde, Frédéric, F-38050 Grenoble Cédex (FR)
(74) Mandataire: Jouvray, Marie-Andrée

(56) Documents cités:
- EP-A- 0 246 460
- ELECTRO CONF. RECORD, vol. 4, 24-26 avril 1979, section 6/2, pages 1-7; R.D. GOLDBLUM: "EMI testing of metalized plastics"
- IEE PROCEEDINGS, sections A - I, vol. 131, no. 1, partie A, janvier 1984, pages 74-78, Old Woking, Surrey, GB; M. ROUSSEAU et al.: "Optically coupled probe for microwave near-field measurements"
- IEEE ANTENNAS & PROPAGATION SOCIETY NEWSLETTER, vol. 26, no. 5, octobre 1984, pages 5-9, W.R. Stone; J.C. WYSS: "Photonic sensors for electomagnetic field measurements"
- 1986 IEEE INTERNATIONAL SYMPOSUM ON ELECTOMAGNETIC COMPATIBILITY, 16-18 septembre 1986, Symposium Record, pages 416-422, IEEE, San Diego, California, US; P.B. PAPAZIAN et al.: "Measurement of seam impedances of tactical shelters for threat level nemp simulation"

## Description

L'invention concerne un procédé de contrôle d'un écran électromagnétique quasi-fermé comportant l'émission, à l'intérieur de l'écran, de signaux électromagnétiques et la détection par au moins un ensemble de réception disposé à l'extérieur de l'écran des signaux électromagnétiques transmis travers l'écran, ainsi qu'un dispositif pour la mise en oeuvre de ce procédé.

Les techniques de blindage d'un local, par exemple au moyen d'une cage de Faraday, pour protéger des appareils vis à vis de perturbations électromagnétiques d'origine externe sont largement utilisées. Cependant, cette protection n'est assurée correctement que si les contacts mobiles destinés à assurer l'étanchéité électromagnétique au niveau des ouvertures, telles que les portes et les fenêtres, sont en bon état.

Le vieillisement inévitable de ces contacts rend nécessaire une vérification périodique de la qualité du blindage. Il est connu, (premier procédé) de déterminer l'efficacité d'un blindage constitué par un écran électromagnétique quasi-fermé en mesurant à l'extérieur de celui-ci, à l'aide d'un dispositif sélectif de mesure, le champ électromagnétique produit par un générateur de courant alternatif de fréquence prédéterminée dont la sortie est reliée à une antenne cadre, l'antenne et le générateur étant disposés à l'intérieur de l'écran. Un dispositif similaire dans lequel le dispositif de mesure est à l'intérieur de l'écran, et l'ensemble antenne générateur à l'extérieur de l'écran, est également connu (deuxième procédé). Les fréquences généralement utilisées sont comprises entre 1kHz et 100kHz, car à ces fréquences les écrans électromagnétiques usuels sont peu performants. A titre d'exemple l'atténuation due à l'écran vaut typiquement 80 dB à 100kHz, 60 dB à 10kHz et 40 dB à 1kHz. Il est ainsi facile de mesurer à l'extérieur les ondes électromagnétiques traversant l'écran, la diminution de l'atténuation étant représentative de la qualité du blindage.

Le document Electro. conf. record, vol. 4, 24-26 Avril 1979, section 6/2, pages 1-7; R.D. Goldblum: "EMI testing of metalized plastics" décrit le test d'un écran électromagnétique employant un ensemble d'émission disposé à l'intérieur d'une chambre, l'écran à tester étant une partie de cette chambre. Le document IEE Proceedings, vol 131, no.1, partie A, janvier 1984, pages 74-78; M. Rousseau et al: "Optically coupled probe for microwave near-field measurements" décrit une sonde de mesure de champs électromagnétiques. Cette sonde est reliée par une fibre optique à un détecteur de phase et d'amplitude.

L'invention a pour but un procédé et un dispositif de contrôle continu permettant de détecter tout fonctionnement défectueux de l'écran électromagnétique.

L'utilisation en continu d'un des procédés connus n'est pas souhaitable car elle implique un rayonnement électromagnétique important vers l'extérieur, en cas de défaut de l'écran pour le premier procédé, et dans tous les cas pour le second procédé. Ceci est à écarter pour des raisons de pollution électromagnétique et, pour certaines applications, notamment pour les applications militaires, pour des raisons de sécurité. Le rayonnement électromagnétique produit par le dispositif selon l'invention doit donc être indétectable par tout équipement situé hors de l'écran autre que l'ensemble de réception du dispositif de contrôle. De plus il est préférable que ce rayonnement soit le plus faible possible de manière à ne pas perturber les appareils à protéger, disposés à l'intérieur de l'écran.

Selon l'invention, ce but est atteint par l'émission, par un ensemble d'émission disposé à l'intérieur de l'écran, de signaux électromagnétiques de faible puissance, à variation aléatoire de fréquence, ces signaux étant transmis à chaque ensemble de réception par une première voie de transmission, de type électromagnétique, une seconde voie de transmission séparée, insensible au blindage électromagnétique constitué par l'écran et ne produisant pas de perturbations électromagnétiques, reliant les ensembles d'émission et de réception, de manière à permettre une détection synchrone des signaux transmis par voie électromagnétique à travers l'écran.

Un dispositif pour la mise en oeuvre du procédé selon l'invention, comportant un ensemble d'émission de signaux électromagnétiques disposé à l'intérieur de l'écran et au moins un ensemble de réception disposé à l'extérieur de l'écran et destiné à réaliser une mesure sélective électromagnétique est caractérisé en ce que l'ensemble d'émission comporte un générateur de signaux à variation aléatoire ou pseudo-aléatoire de fréquence, de faible puissance, dont les signaux de sortie sont transmis à chaque ensemble de réception par une première voie de transmission, de type électromagnétique, allant d'une antenne émettrice de l'ensemble d'émission, connectée à la sortie du générateur, à une antenne réceptrice de l'ensemble de réception connectée à une première entrée d'un récepteur à détection synchrone, une seconde voie de transmission, insensible au blindage électromagnétique constitué par l'écran et ne produisant pas de perturbations électromagnétiques, reliant les ensembles d'émission et de réception de manière à permettre une détection synchrone des signaux transmis par voie électromagnétique à travers l'écran.

Lorsque le générateur est un générateur de fréquence aléatoire, la seconde voie de transmission transmet les signaux de sortie du générateur à une seconde entrée, de référence de phase, du récepteur à détection synchrone. Lorsque le générateur est un générateur de fréquence pseudo-aléatoire contrôlé par un dispositif pilote relié à l'ensemble d'émission et au récepteur à détection synchrone, la seconde voie de transmission relie l'ensemble d'émission au dispositif pilote lorsque celui-ci est disposé à l'extérieur de l'écran et l'ensemble de réception au dispositif pilote lorsque celui-ci est disposé à l'intérieur de l'écran.

La seconde voie de transmission est de préférence une voie de transmission optique utilisant au moins une fibre optique traversant l'écran.

Selon un développement de l'invention l'ensemble d'émission comporte une pluralité de sorties respectivement reliées par une fibre optique associée à un ensemble de réception correspondant.

La fréquence des signaux émis par le générateur varie dans une plage compris entre 1 et 100kHz .

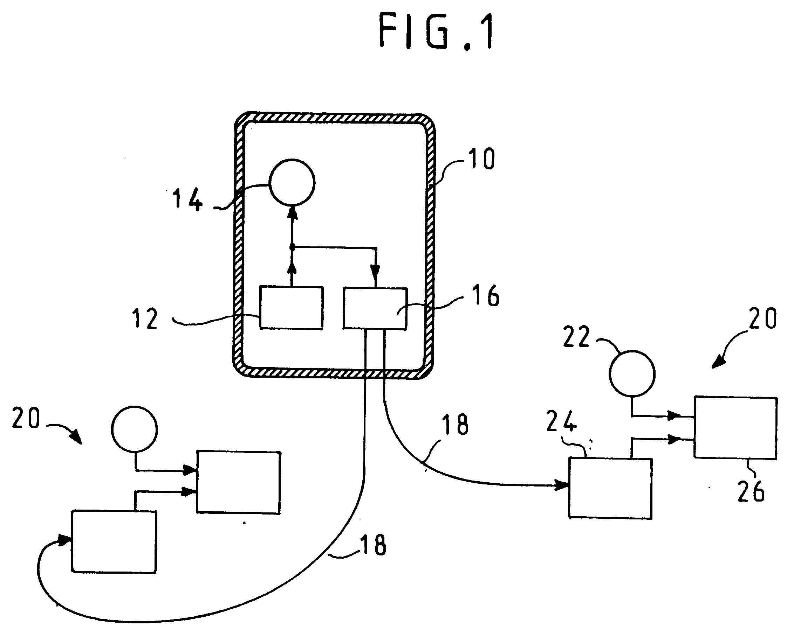

D'autres avantages et caractéristiques resssortiront plus clairement de l'exposé qui va suivre d'un mode particulier de réalisation de l'invention, donné à titre d'exemple non limitatif et représenté sur la figure unique, représentant schématiquement un dispositif de contrôle selon l'invention.

A l'intérieur d'un écran électromagnétique quasi-fermé 10 à contrôler, est disposé un ensemble émetteur. Ce dispositif comporte un générateur 12 de signaux électriques à variation aléatoire de fréquence, la fréquence instantanée variant dans une plage contenue dans la bande de fréquences 1-100kHz. La sortie du générateur est connectée à une antenne émettrice 14, du type antenne-cadre, ainsi qu'à un dispositif de conversion électro-optique 16 fournissant en sortie, sur une ou plusieurs voies, des signaux optiques représentatifs des signaux électriques qui lui sont appliqués. Chaque sortie du dispositif de conversion 16 est connectée à une fibre optique 18 traversant l'écran 10 et reliée à un ensemble de réception 20 associé.

Il est évident que l'ensemble émetteur est représenté à une échelle très agrandie sur la figure, celui-ci ne remplissant en fait qu'une petite partie du volume interne à l'écran qui contient les divers appareils (non représentés) à protéger vis à vis de perturbations électromagnétiques externes.

On a représenté sur la figure, deux ensembles de réception 20. Un dispositif de contrôle selon l'invention doit comporter au moins un de ces ensembles, mais on peut également prévoir un plus grand nombre d'ensembles de réception identiques, connectés chacun à l'ensemble émetteur disposé à l'intérieur de l'écran par une fibre optique associée 18, les ensembles de réception 20 étant disposés à des emplacements appropriés autour de l'écran afin de pouvoir localiser toute fuite de cet écran.

Chaque ensemble de réception 20 comporte une antenne réceptrice 22, du type antenne-cadre, un dispositif 24 de réception de signaux optiques, connecté à la fibre optique associée 18 et convertissant les signaux optiques qu'il reçoit en signaux électriques. L'antenne 22 est connectée à une entrée signal d'un récepteur à détection synchrone 26 dont l'entrée référence de phase est connectée à la sortie du dispositif 24 de réception de signaux optiques.

Le dispositif de contrôle décrit ci-dessus fonctionne de la manière suivante:

Le générateur 12 et l'antenne émettrice 14 produisent en permanence des signaux électromagnétiques de faible puissance à variation de fréquence aléatoire. Ces signaux sont assimilables à un bruit et produisent à l'extérieur de l'écran un champ dont l'amplitude est inférieure au bruit naturel. Ce champ est donc indétectable de l'extérieur, sauf par les ensembles de réception 20. La fréquence variant dans une plage comprise entre 1 et 100kHz, c'est à dire dans la partie basse du spectre radio-fréquence, et leur amplitude étant très faible, les champs présents à l'intérieur de l'écran ne risquent pas de perturber les appareils à protéger disposés à l'intérieur de l'écran électromagnétique, tout en étant détectables de l'extérieur au moyen d'un récepteur à détection synchrone.

Pour permetttre la détection synchrone des signaux électromagnétiques transmis à travers l'écran 10, la transmission se fait par deux voies séparées. La première voie de transmission, de l'antenne émettrice 14 à l'antenne réceptrice 22, permet d'appliquer sur l'entrée signal du récepteur à détection synchrone 26 des signaux représentatifs de la qualité de l'écran électromagnétique. La seconde voie de transmission, par voie optique dans le mode de réalisation préférentiel représenté sur la figure, fournit à l'entrée référence de phase du récepteur à détection synchrone, des signaux représentatifs des signaux électromagnétiques émis par l'ensemble d'émission disposé à l'intérieur de l'écran. Cette seconde voie de transmission est insensible au blindage et n'émet pas de perturbations électromagnétiques.

Le récepteur à détection synchrone 26 peut alors détecter un signal extrèmement faible produit par l'antenne émettrice 14, tandis que tout autre dispositif de détection, ne disposant pas des informations transmises par la fibre optique, ne peut distinguer ces signaux des signaux de bruit produits par d'autres sources.

On peut ainsi contrôler de manière efficace, en permanence, la qualité du blindage, sans que le champ électromagnétique émis par l'ensemble émetteur risque de perturber les appareils à protéger disposés à l'intérieur de l'écran, et sans que ce champ soit détectable de l'extérieur par d'autres moyens que les ensembles de réception du dispositif de contrôle.

Les signaux de sortie des récepteurs à détection synchrone 26, qui sont représentatifs de la qualité du blindage, peuvent être utilisés de toute manière appropriée pour fournir une indication, par exemple visuelle ou auditive, lorsqu'une intervention de maintenance est nécessaire. Ces signaux peuvent être retransmis à un dispositif de traitement disposé à l'intérieur de l'écran au moyen de liaisons par fibres optiques (non représentées).

Selon un second mode de réalisation, non représenté, le générateur disposé à l'intérieur de l'écran est constitué par un générateur de signaux à variation pseudo-aléatoire de fréquence contrôlé par un dispositif pilote. Ce dernier peut être disposé soit à l'intérieur, soit à l'extérieur de l'écran. Dans les deux cas la seconde voie de transmission, insensible au blindage électromagnétique constitué par l'écran, est utilisée pour transmettre un signal représentatif du signal de synchronisation fourni par le dispositif pilote au générateur. Si le dispositif pilote est situé à l'intérieur de l'écran, ce signal est appliqué à une seconde entrée du récepteur à détection synchrone qui, après décodage, l'utilise pour la détection des signaux transmis par voie électromagnétique à travers l'écran. Lorsque le dispositif pilote est disposé à l'extérieur de l'écran, il envoie par la seconde voie de transmission, le signal de synchronisation au générateur et il est connecté à la seconde entrée du récepteur à détection synchrone de chaque ensemble de transmission sur laquelle il applique un signal représentatif de ce signal de synchronisation.

L'invention n'est pas limitée à une seconde voie de transmission utilisant une transmission par fibre optique comme décrit ci-dessus. Tout moyen permettant de transmettre des signaux de l'intérieur d'un écran électromagnétique vers l'extérieur ou inversement sans être influencé par le blindage et sans émettre de perturbations électromagnétiques peut être utilisé. A titre d'exemples, on peut citer la transmission par infrarouges, par un faisceau optique, par ultrasons, par rayons X ou même par un câble électrique très soigneusement blindé traversant l'écran.

## Revendications

1. Procédé de contrôle d'un écran électromagnétique quasi-fermé (10) comportant l'émission, par un ensemble d'émission disposé à l'intérieur de l'écran, de signaux électromagnétiques et la détection par au moins un ensemble de réception disposé à l'extérieur de l'écran des signaux électromagnétiques transmis à travers l'écran, caractérisé en ce qu'il consiste à émettre à l'intérieur de l'écran des signaux électromagnétiques de faible puissance, à variation aléatoire ou pseudo-aléatoire de fréquence, ces signaux étant transmis à chaque ensemble de réception (20) par une première voie de transmission (14,22), de type électromagnétique, une seconde voie de transmission séparée (16,18,24), insensible au blindage électromagnétique constitué par l'écran et ne produisant pas de perturbations électromagnétiques, reliant les ensembles d'émission et de réception, de manière à permettre une détection synchrone des signaux transmis par voie électromagnétique à travers l'écran.

2. Dispositif de contrôle d'un écran électromagnétique quasi-fermé (10) pour la mise en oeuvre du procédé selon la revendication 1, comportant un ensemble (12,14) d'émission de signaux électromagnétiques disposé à l'intérieur de l'écran et au moins un ensemble de réception (20) disposé à l'extérieur de l'écran et destiné à réaliser une mesure sélective du champ électromagnétique, dispositif caractérisé en ce que l'ensemble d'émission comporte un générateur (12) de signaux à variation aléatoire ou pseudo-aléatoire de fréquence, de faible puissance, dont les signaux de sortie sont transmis à chaque ensemble de réception (20) par une première voie de transmission, de type électromagnétique, allant d'une antenne émettrice (14) de l'ensemble d'émission, connectée à la sortie du générateur (12), à une antenne réceptrice (22) de l'ensemble de réception (20) connectée à une première entrée d'un récepteur à détection synchrone (26), une seconde voie de transmission (18), insensible au blindage électromagnétique constitué par l'écran et ne produisant pas de perturbations électromagnétiques, reliant les ensembles d'émission et de réception de manière à permettre une détection synchrone des signaux transmis par voie électromagnétique à travers l'écran (10).

3. Dispositif selon la revendication 2, caractérisé en ce que le générateur est un générateur de fréquence aléatoire, la seconde voie de transmission transmettant les signaux de sortie du générateur (12) à une seconde entrée, de référence de phase, du récepteur à détection synchrone (26).

4. Dispositif selon la revendication 2, caractérisé en ce que le générateur est un générateur de fréquence pseudo-aléatoire contrôlé par un dispositif pilote relié à l'ensemble d'émission et au récepteur à détection synchrone, la seconde voie de transmission reliant l'ensemble d'émission au dispositif pilote lorsque celui-ci est disposé à l'extérieur de l'écran et l'ensemble de réception au dispositif pilote lorsque celui-ci est disposé à l'intérieur de l'écran.

5. Dispositif selon l'une quelconque des revendications 2 à 4, caractérisé en ce que la seconde voie est une voie de transmission optique, de préférence par fibre optique (18).

6. Dispositif selon la revendication 5, caractérisé en ce que l'ensemble d'émission comporte une pluralité de sorties respectivement reliées par une fibre optique (18) associée à un ensemble de réception (20) correspondant.

7. Dispositif selon l'une quelconque des revendications 2 à 4, caractérisé en ce que la seconde voie est une voie de transmission par infrarouges.

8. Dispositif selon l'une quelconque des revendications 2 à 4, caractérisé en ce que la seconde voie est une voie de transmission par ultrasons.

9. Dispositif selon l'une quelconque des revendications 2 à 8, caractérisé en ce que la fréquence des signaux émis par le générateur (12) est comprise dans la partie basse du spectre radio-fréquence.

10. Dispositif selon la revendication 9, caractérisé en ce que la fréquence des signaux émis par le générateur (12) varie dans une plage comprise entre 1 et 100kHz.

## Claims

1. A monitoring process of a quasi-closed electromagnetic shield (10) comprising emission, by an emitter assembly located inside the shield, of electromagnetic signals and detection by at least one receiver assembly located outside the shield of the electromagnetic signals transmitted through the shield, characterised in that it consists in emitting inside the shield low-power electromagnetic signals, with random or pseudo-random frequency variation, these signals being transmitted to each receiver assembly (20) by a first transmission channel (14, 22), of the electromagnetic type, a second separate transmission channel (16, 18, 24), insensitive to the electromagnetic shielding constituted by the shield and not producing any electromagnetic interference, connecting the emitter and receiver assemblies, in such a way as to enable synchronous detection of the signals transmitted via an electromagnetic channel through the shield.

2. A monitoring device of a quasi-closed electromagnetic shield (10) for implementation of the process according to claim 1, comprising an electromagnetic signal emitter assembly (12, 14) housed inside the shield and at least one receiver assembly (20) located outside the shield and designed to perform selective measurement of the electromagnetic field, a device characterised in that the emitter assembly comprises a low-power signal generator (12) with random or pseudo-random frequency variation, whose output signals are transmitted to each receiver assembly (20) by a first transmission channel, of the electromagnetic type, going from an emitter antenna (14) of the emitter assembly, connected to the output of the generator (12), to a receiver antenna (22) of the receiver assembly (20) connected to a first input of a synchronous detection receiver (26), a second transmission channel (18), insensitive to the electromagnetic shielding constituted by the shield and not producing any electromagnetic interference, connecting the emitter and receiver assemblies in such a way as to enable synchronous detection of the signals transmitted via an electromagnetic channel through the shield (10).

3. The device according to claim 2, characterised in that the generator is a random frequency generator, the second transmission channel transmitting the signals output from the generator (12) to a second, phase reference, input of the synchronous detection receiver (26).

4. The device according to claim 2, characterised in that the generator is a pseudo-random frequency generator controlled by a control device connected to the emitter assembly and to the synchronous detection receiver, the second transmission channel connecting the emitter assembly to the control device when the latter is located outside the shield and the receiver assembly to the control device when the latter is located inside the shield.

5. The device according to any one of the claims 2 to 4, characterised in that the second channel is an optic transmission channel, preferably by optic fiber (18).

6. The device according to claim 5, characterised in that the emitter assembly comprises a plurality of outputs respectively connected by an optic fiber (18) associated with a corresponding receiver assembly (20).

7. The device according to any one of the claims 2 to 4, characterised in that the second channel is an infrared transmission channel.

8. The device according to any one of the claims 2 to 4, characterised in that the second channel is an ultrasound transmission channel.

9. The device according to any one of the claims 2 to 8, characterised in that the frequency of the signals emitted by the generator (12) is comprised in the lower part of the radio-frequency spectrum.

10. The device according to claim 9, characterised in that the frequency of the signals emitted by the generator (12) varies within a range comprised between 1 and 100kHz.

## Patentansprüche

1. Verfahren zur Überprüfung einer quasi-geschlossenen elektromagnetischen Abschirmung (10), bestehend aus der Aussendung elektromagnetischer Signale durch eine innerhalb der Abschirmung angeordnete Sendeeinheit und der Erfassung der durch die Abschirmung hindurchgetretenen elektromagnetischen Signale durch mindestens eine außerhalb der Abschirmung angeordnete Empfangseinheit, dadurch gekennzeichnet, daß innerhalb der Abschirmung elektromagnetische Signale mit geringer Intensität und frei oder quasi-frei veränderlicher Frequenz ausgesandt werden, wobei diese Signale jeder einzelnen Empfangseinheit (20) über einen ersten elektromagnetischen Übertragungsweg (14, 22) und einen zweiten getrennten Übertragungsweg (16, 18, 24) zugeführt werden, der durch die elektromagnetische Abschirmung nicht beeinflußt wird, keine elektromagnetischen Störungen hervorruft und die Sende- und Empfangseinheiten miteinander verbindet, so daß eine synchrone Erfassung der über den elektromagnetischen Übertragungsweg durch die Abschirmung hindurch übertragenen Signale möglich ist.

2. Anordnung zur Überprüfung einer quasi-geschlossenen elektromagnetischen Abschirmung (10) zur Durchführung des Verfahrens nach Anspruch 1, die eine innerhalb der Abschirmung angeordneten Sendeeinheit (12, 14) zur Aussendung elektromagnetischer Signale sowie mindestens eine außerhalb der Abschirmung angeordneten Empfangseinheit (20) zur selektiven Messung des magnetischen Feldes aufweist, dadurch gekennzeichnet, daß die Sendeeinheit einen Signalgenerator (12) zur Erzeugung von Signalen geringer Stärke und frei oder quasi-frei veränderlicher Frequenz umfaßt, dessen Ausgangssignale jeder einzelnen Empfangseinheit (20) über einen ersten elektromagnetischen Übertragungsweg, der von einer an den Ausgang des Signalgenerators (12) angeschlossenen Sendeantenne (14) der Sendeeinheit bis zu einer an einen ersten Eingang eines Synchron-Meßempfängers (26) angeschlossenen Empfangsantenne (22) der Empfangseinheit (20) verläuft, sowie einen zweiten Übertragungsweg (18) zugeführt werden, der durch die elektromagnetische Abschirmung nicht beeinflußt wird, keine elektromagnetischen Störungen hervorruft und die Sende- und Empfangseinheiten miteinander ver bindet, so daß eine synchrone Erfassung der über den elektromagnetischen Übertragungsweg durch die Abschirmung (10) hindurch übertragenen Signale möglich ist.

3. Anordnung nach Anspruch 2, dadurch gekennzeichnet, daß der Signalgenerator mit frei veränderlicher Frequenz arbeitet und der zweite Übertragungsweg die Ausgangssignale des Signalgenerators (12) einem zweiten Phasenbezugseingang des Synchron-Meßempfängers (26) zuführt.

4. Anordnung nach Anspruch 2, dadurch gekennzeichnet, daß der Signalgenerator mit quasi-frei veränderlicher Frequenz arbeitet und mit einer an die Sendeeinheit und den Synchron-Meßempfänger angeschlossenen Steuereinheit verbunden ist, wobei der zweite Übertragungsweg die Steuereinheit bei deren Anordnung außerhalb der Abschirmung mit der Sendeeinheit und bei Anordnung innerhalb der Abschirmung mit der Empfangseinheit verbindet.

5. Anordnung nach einem der Ansprüche 2 bis 4, dadurch gekennzeichnet, daß der zweite Übertragungsweg als optischer Übertragungsweg, vorzugsweise als Lichtwellenleiter (18) ausgeführt ist.

6. Anordnung nach Anspruch 5, dadurch gekennzeichnet, daß die Sendeeinheit mehrere Ausgänge aufweist, die über zugeordnete Lichtwellenleiter (18) mit einer entsprechenden Empfangseinheit (20) verbunden sind.

7. Anordnung nach einem der Ansprüche 2 bis 4, dadurch gekennzeichnet, daß der zweite Übertragungsweg als Infrarot-Strecke ausgeführt ist.

8. Anordnung nach einem der Ansprüche 2 bis 4, dadurch gekennzeichnet, daß der zweite Übertragungsweg als Ultraschall-Strecke ausgeführt ist.

9. Anordnung nach einem der Ansprüche 2 bis 8, dadurch gekennzeichnet, daß die Frequenz der vom Signalgenerator (12) ausgesandten Signale im unteren Bereich des Funkfrequenzspektrums liegt.

10. Anordnung nach Anspruch 9, dadurch gekennzeichnet, daß die Frequenz der vom Signalgenerator (12) ausgesandten Signale im Bereich von 1 bis 100 kHz schwankt.
